# EUROPEAN PATENT APPLICATION

(11) **EP 2 445 021 A2**
(43) Date of publication of application: **25.04.2012**
(21) Application number: 11185772.8
(22) Date of filing: 19.10.2011
(51) Int. Cl.: H01L 33/54, H01L 25/075, H01L 33/56

(54) **Lighting emitting diode (LED) package and method of fabrication**

(30) Priority: 21.10.2010 US 909367
(71) Applicant: Semileds Optoelectronics Co., Ltd., Miao-Li County (TW)
(72) Inventor: Liu, Wen-Huang, 30644 Hsinchu County (TW); Dan, Chung-Che, 220 Taipei County (TW); Chang, Yuan-Hsiao, 428 Taichung County (TW); Kao, Hung-Jen, 116 Taipei City (TW); Chu, Chen-Fu, 300 Hsinchu City (TW); Cheng, Hao-Chun, 302 Hsinchu county (TW)
(74) Representative: Ergün, Mevci

(57) **Abstract**

A light emitting diode (LED) package includes a substrate, a light emitting diode (LED) die mounted to the substrate, a frame on the substrate, a wire bonded to the light emitting diode (LED) die and to the substrate, and a transparent dome configured as a lens encapsulating the light emitting diode (LED) die. A method for fabricating a light emitting diode (LED) package includes the steps of: providing a substrate; forming a frame on the substrate; attaching a light emitting diode (LED) die to the substrate; wire bonding a wire to the light emitting diode (LED) die and to the substrate; and dispensing a transparent encapsulation material on the frame configured to form a transparent dome and lens for encapsulating the light emitting diode (LED) die.

## Description

### Background

This disclosure relates generally to optoelectronic components and more particularly to light emitting diode (LED) packages, and to methods for fabricating the light emitting diode (LED) packages.

A light emitting diode (LED) package can include a substrate, a light emitting diode (LED) die mounted to the substrate, and a dome or lens encapsulating the die. The dome can comprise a transparent material, such as a polymer resin, which is typically formed using an injection molding process or a compression molding process. The molding process can be performed on a wafer comprised of multiple substrates, with each substrate having at least one light emitting diode (LED) die mounted thereon. Following the molding process, the wafer can be singulated into separate light emitting diode (LED) packages.

One shortcoming of the molding process is that it is difficult to prevent the polymer resin from forming on areas of the wafer where it is not needed. For example, the polymer resin can cover areas between the packages on the wafer, and areas outside of the transparent domes on individual substrates. This problem can result from the mold design or from mold flash. The unwanted polymer resin can adversely affect the wafer singulation process, and can cause the domes to separate from the substrates. In addition to this problem, the molding equipment is expensive to make and expensive to operate. For example, each package requires a particular mold for a dome size and emitting pattern such that many molds are required for a product line.

The present disclosure is directed to a light emitting diode (LED) package and to a method for fabricating the light emitting diode (LED) package that overcomes some of the problems associated with packages having domes fabricated using a molding process.

### Summary

A light emitting diode (LED) package includes a substrate, a light emitting diode (LED) die mounted to the substrate, a frame on the substrate, a wire bonded to the light emitting diode (LED) die and to the substrate, and a transparent dome configured as a lens encapsulating the light emitting diode (LED) die. The frame preferably comprises a transparent material formed with a desired height and peripheral shape on the substrate, which is configured to locate, support and shape the transparent dome. For example, the frame can have a circular, polygonal, elliptical, peanut, or oval peripheral shape, that encloses the light emitting diode (LED) die. In addition, either a single light emitting diode (LED) die, or multiple light emitting diode (LED) dice, can be enclosed by the frame and encapsulated by the transparent dome. Further, the light emitting diode (LED) die can also include a wavelength converting layer. As another alternative, multiple light emitting diode (LED) dice having different sizes and light emission characteristics can be enclosed by the frame and encapsulated by the transparent dome.

A method for fabricating a light emitting diode (LED) package includes the steps of: providing a substrate; forming a frame on the substrate; attaching a light emitting diode (LED) die to the substrate proximate to the frame; wire bonding a wire to the light emitting diode (LED) die and to the substrate; and dispensing a transparent encapsulation material on the frame configured to form a transparent dome and lens for encapsulating the light emitting diode (LED) die. The substrate can be contained on a wafer of material, such that a wafer level fabrication process can be performed. During the dispensing step, the frame provides a dam for containing the encapsulation material and forming the outer peripheral shape of the dome. This allows a dispensing process, rather than a molding process, to be used to form the transparent dome. The method can also include the step of forming a wavelength converting layer on the light emitting diode (LED) die. As another alternative, the method can include the step of attaching multiple light emitting (LED) dice to the substrate, and forming the dome on the dice.

### Brief Description of the Drawings

Exemplary embodiments are illustrated in the referenced figures of the drawings. It is intended that the embodiments and the figures disclosed herein are to be considered illustrative rather than limiting.

Figure 1A is a schematic cross sectional view of a light emitting diode (LED) package having a frame and transparent dome;

Figure 1B is a schematic plan view of the light emitting diode (LED) package of Figure 1A;

Figure 2 is a schematic plan view of an alternate embodiment light emitting diode (LED) package having multiple dice;

Figure 3 is a schematic plan view of an alternate embodiment light emitting diode (LED) package having multiple dice with different light emission characteristics;

Figure 4 is a schematic cross sectional view of an alternate embodiment light emitting diode (LED) package having a die with a wavelength converting layer;

Figure 5 is a schematic cross sectional view of an alternate embodiment light emitting diode (LED) package having multiple dice including a die with a wavelength converting layer;

Figure 6 is a schematic plan view of an alternate embodiment wafer sized light emitting diode (LED) package having multiple frames, dice and transparent domes;

Figures 7A-7E are schematic cross sectional views illustrating steps in a method for fabricating the light emitting diode package; and

Figure 8 is a flow chart illustrating different process flows for the method.

### Detailed Description

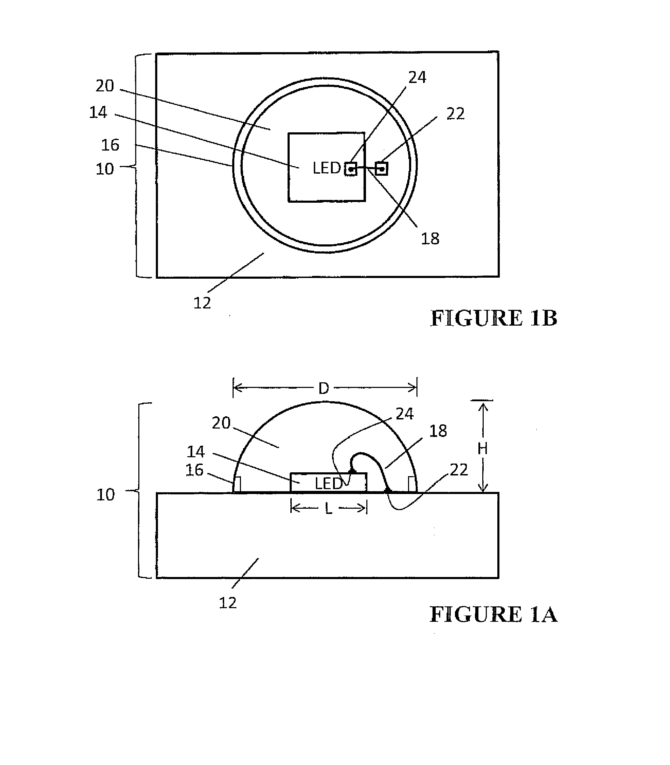

Referring to Figures 1A and 1B, a light emitting diode (LED) package 10 includes a substrate 12; a light emitting diode (LED) die 14 mounted to the substrate 12; a frame 16 on the substrate 12; a ware 18 bonded to the light emitting diode (LED) die 14 and to the substrate 12; and a transparent dome 20 configured as a lens encapsulating the light emitting diode (LED) die 14.

The substrate 12 (Figures 1A and 1B) functions as a mounting substrate, and also provides electrical conductors (not shown), electrodes (not shown) and electrical circuits (not shown) for electrically connecting the light emitting diode (LED) package 10 to the outside world. The substrate 12 can have a flat shape as shown or can have a convex shape or a concave shape. In addition, the substrate 12 can include a reflective layer (not shown) to improve light extraction. The substrate 12 can comprise silicon, or another semiconductor material such as GaAs, SiC, GaP, GaN or AlN. Alternately, the substrate 12 can comprise a ceramic material, sapphire, glass, a printed circuit board (PCB) material, a metal core printed circuit board (MCPCB), an FR-4 printed circuit board (PCB), a metal matrix composite, a metal lead frame, an organic lead frame, a silicon submount substrate, or any packaging substrate used in the art. Further, the substrate 12 can comprise a single layer of metal or metal alloyed layers, or multiple layers such as Si, AlN, SiC, AlSiC, diamond, MMC, graphite, Al, Cu, Ni, Fe, Mo, CuW, CuMo, copper oxide, sapphire, glass, ceramic, metal or metal alloy. In any case, the substrate 12 preferably has an operating temperature range of from about 60 °C to 350°C.

The substrate 12 (Figures 1A and 1B) can have any polygonal shape (e.g., square, rectangular) and any suitable size. For example, the substrate 12 can be die-sized, such that the light emitting diode (LED) package 10 has a chip scale size similar to that of a chip scale package (CSP). Alternately, the substrate 12 can be wafer sized such that a wafer scale system with a plurality of light emitting diode (LED) dice 14 is provided. Further, the substrate 12 can have a desired thickness, with from 35 µm to 3000 µm being representative. In addition, the substrate 12 includes a substrate contact 22 in electrical communication with conductors (not shown), and terminal contacts (not shown) on the substrate 12 configured for electrical connection to a mother board, circuit board or other support substrate (not shown) for mounting and electrically connecting the light emitting diode (LED) package 10 in a LED system.

The light emitting diode (LED) die 14 (Figures 1A and 1B) can comprise a conventional LED fabricated using known processes. The light emitting diode (LED) die 14 preferably has a peak wavelength of from about 250 nm to 2000 nm. Suitable light emitting diode (LED) dice are commercially available from SEMILEDS, INC. located in Boise, ID and Miao-Li County, Taiwan, R.O.C. The light emitting diode (LED) die 14 includes a die contact 24, and the wire 18 can be wire bonded to the die contact 24 and to the substrate contact 22 on the substrate 12. In addition, the light emitting diode (LED) die 14 can be electrically attached to electrodes (not shown) on the substrate 12 using a die attach adhesive layer (not shown), or other suitable attachment system (e.g., solder).

The frame 16 (Figures 1A and 1B) preferably comprises a transparent material deposited on the substrate 12 using a suitable deposition process. Suitable materials for the frame 16 include polymer materials such as epoxy, silicone, polyimide, parylene and benzocyctobutene (BCB). In addition, these polymer materials can include fillers such as silicates configured to reduce the coefficient of thermal expansion (CTE) and adjust the viscosity of the polymer material. The frame 16 can also comprise an acrylic, a polyacrylamide (PC), a poly methyl methacrylate (PMMA), a glass, a silicone or a quartz material. As another the frame 16 can comprise an imageable material such as a photo resist, such as "EPON RESIN SU-8". The frame 16 can also comprise a metal such as Al, Ti, Ag, Au, Cu, Cr, Ni, Co or TiW. The frame 16 can also comprise an etched portion of the substrate 12, such as a recess etched into the substrate 12 to a depth equal to the height or thickness of a deposited material.

Suitable processes for forming the frame 16 (Figures 1A and 1B) include spin-coating, lithography, dip-coating, dispensing using a material dispensing system, printing, jetting, spraying, chemical vapor deposition (CVD), thermal evaporation, e-beam evaporation and adhesive. In addition, the frame 16 can comprise a single layer of material or multiple layers of material. Also, rather than comprising a deposited material, the frame 16 can comprise a recess etched into the substrate 12 to a depth equal to the height or thickness of the frame 16. The frame 16 preferably has a peripheral shape that encloses the light emitting diode (LED) die 14. Suitable peripheral shapes for the frame 16 include circular, polygonal, elliptical, peanut, oval, square, rectangular and oblong. The width, length and diameter of the frame 14 can be selected as required, with from about 1 µm to 3000 µm being representative. A height or thickness of the frame 16 on the substrate 16 can also be selected as required, with from 0.01 µm to 2000 µm being representative.

The transparent dome 20 (Figures 1A and 1B) functions as a lens that encapsulates the light emitting diode (LED) die 14. Suitable materials for the transparent dome 20 include silicone, epoxy and glass. The transparent dome 20 can comprise one or more layers of material formed using a suitable deposition process such as screen printing, dispensing, precise dispensing, spraying and jetting. The frame 16 is configured to locate, support and shape the transparent dome 20, particularly during the deposition process. Representative parameters for the transparent dome 20 are listed in Table 1.

**Table 1**

| | |
|---|---|
| LED Chip Size (L) | Min. 0.15 mm |
| Lens Diameter (D) | Min. (L) x 1.5 |
| Lens Depth (H) | Max. (D) x 1.0 |
| Others | Undercut shape is available |

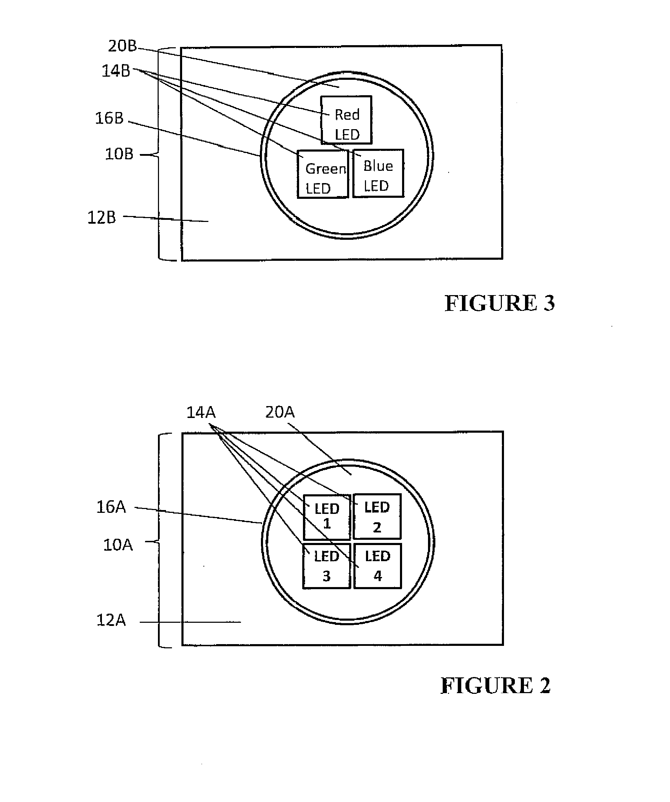

Referring to Figure 2, an alternate embodiment light emitting diode (LED) package 10A includes a substrate 12A; a plurality of light emitting diode (LED) dice 14A mounted to the substrate 12A; a frame 16A on the substrate 12A; and a transparent dome 20A configured as a lens encapsulating the light emitting diode (LED) dice 14A. For simplicity, the wires that connect the light emitting diode (LED) dice 14A to the substrate 12A are not shown.

Referring to Figure 3, an alternate embodiment light emitting diode (LED) package 10B includes a substrate 12B; a plurality of light emitting diode (LED) dice 14B mounted to the substrate 12B having different light emission characteristics such as peak emission; a frame 16B on the substrate 12B; and a transparent dome 20B configured as a lens encapsulating the light emitting diode (LED) dice 14B. For simplicity, the wires that connect the light emitting diode (LED) dice 14B to the substrate 12B are not shown. In addition, the light emitting diode (LED) dice 14B are illustrated as having red, green and blue emission characteristics. However, other arrangements are possible. In addition, the light emitting diode (LED) dice 14B can have a same operation current or different operation current, and can be controlled separately. Still further, the light emitting diode (LED) dice 14B can be electrically connected in parallel or series.

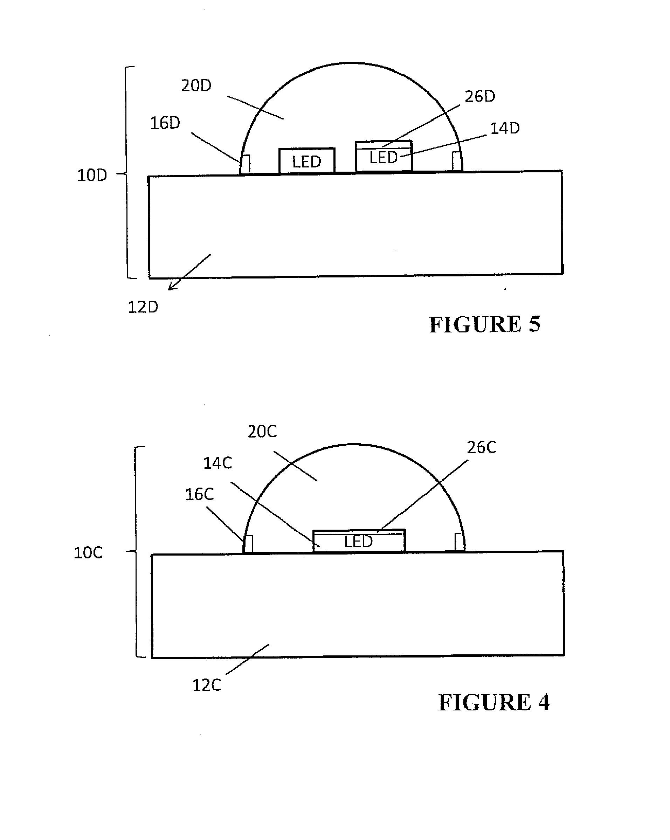

Referring to Figure 4, an alternate embodiment light emitting diode (LED) package 10C includes a substrate 12C; a light emitting diode (LED) die 14C mounted to the substrate 12C having a wavelength converting layer 26C; a frame 16C on the substrate 12C; and a transparent dome 20C configured as a lens encapsulating the light emitting diode (LED) die 14C. For simplicity, the wires that connect the light emitting diode (LED) die 14C to the substrate 12C are not shown. The wavelength converting layer 26C can comprise a resin fluorescent material configured to convert or adjust the wavelength of light emitted by the light emitting diode (LED) die 14C.

Referring to Figure 5, an alternate embodiment light emitting diode (LED) package 10D includes a substrate 12D; a plurality of light emitting diode (LED) dice 14D mounted to the substrate 12D at least one of which has a wavelength converting layer 26D; a frame 16D on the substrate 12D; and a transparent dome 20D configured as a lens encapsulating the light emitting diode (LED) die 14D. For simplicity, the wires that connect the light emitting diode (LED) dice 14D to the substrate 12D are not shown. The wavelength converting layer 26D can comprise a phosphor based material configured to convert or adjust the wavelength of light emitted by the light emitting diode (LED) die 14D.

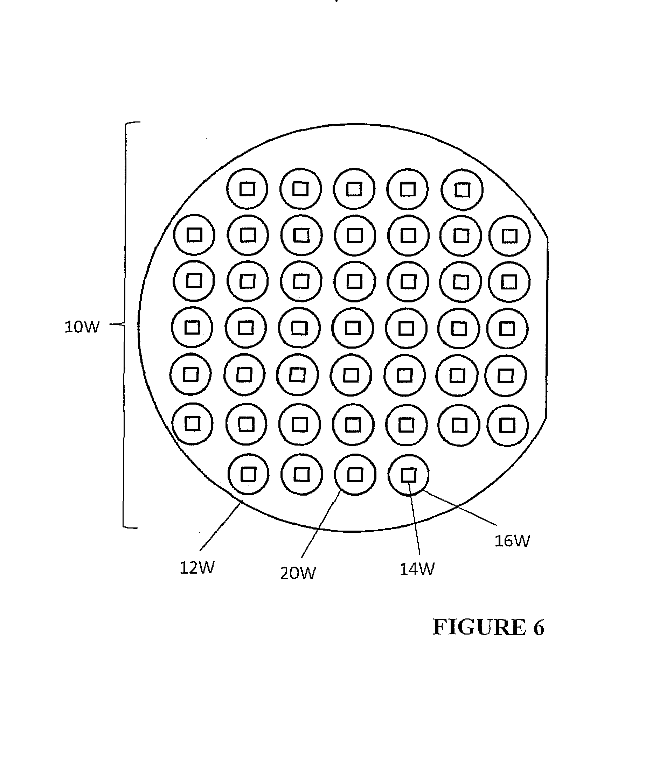

Referring to Figure 6, an alternate embodiment wafer-sized light emitting diode (LED) package 10W includes a wafer-sized substrate 12W; a plurality of light emitting diode (LED) dice 14W mounted to the substrate 12W; a plurality of frames 16W on the substrate 12W; and a plurality of transparent domes 20W configured as a lenses encapsulating the light emitting diode (LED) dice 14W. The wafer-sized substrate 12W can comprise a wafer such as a 150 mm diameter wafer, a 200 mm diameter wafer or a 300 mm diameter wafer. The wafer-sized substrate 12W can also comprise a portion of a wafer or a panel having a desired size and peripheral shape. In addition, the light emitting diode (LED) dice 14W can have the same light emitting characteristics or different light emitting characteristics. In addition, one or more of the light emitting diode (LED) dice 14W can have a wavelength converting layer.

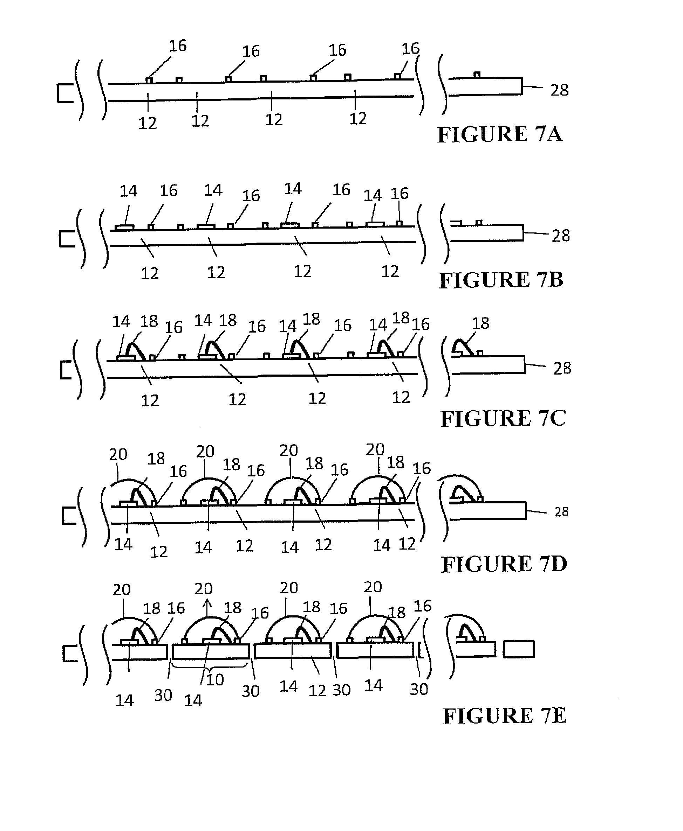

Referring to Figures 7A-7E, steps in a method for fabricating the light emitting diode (LED) package 10 are illustrated. The alternate embodiment light emitting diode (LED) packages 10A-10D and 10W can be fabricated using essentially the same steps. Initially, as shown in Figure 7A, a wafer 28 comprised of a plurality of substrates 12 can be provided. The wafer 28 can comprise a conventional semiconductor wafer having a standard diameter and a full thickness. Alternately, the wafer 28 can comprise a thinned semiconductor wafer. A representative thickness of the wafer 28 can be from 35 µm to 3000 µm. The wafer 28 can include a plurality of metallization patterns (not shown) that includes the substrate contacts 22 (Figure 1B), conductors (not shown), and electrodes (not shown) as required. These metallization patterns can be formed using well known processes such as an additive process (deposition through a mask) or a subtractive process (etching through a mask).

As also shown in Figure 7A, a frame forming step can be performed to form a plurality of frames 16 on the wafer 28. Each substrate 12 includes a frame 16 having a desired location, peripheral shape, and height on the substrate 12. Suitable methods for forming the frames 16 include spin-coating, lithography, dip-coating, dispensing using a material dispensing system, printing, jetting, spraying, chemical vapor deposition (CVD), thermal evaporation and e-beam evaporation. In addition, each frame 16 can be configured to surround a single light emitting diode (LED) die 14, or multiple dice as previously described for the alternate embodiment packages 10A, 10B, 10D. Suitable peripheral shapes for the frames 16 include circular, polygonal, elliptical, peanut, oval, square, rectangular and oblong as previously described. Further, the frames 16 can be formed of the previously described materials including polymers, epoxy, silicone, glass, quartz, resist or a metal.

Next, as shown in Figure 7B, a die mounting step can be performed to mount the light emitting diode (LED) dice 14 on the substrates 12 in electrical contact with electrodes (not shown) on the wafer 28. A bonding layer (not shown) can be formed using a solder reflow process, a bumping process or a silver epoxy curing process to bond the light emitting diode (LED) dice 14 to the electrodes (not shown) on the wafer 28. The light emitting diode (LED) dice 14 can comprise conventional LED dice fabricated using known processes. Suitable LED dice are commercially available from SEMILEDS, INC. located in Boise, ID and Miao-Li County, Taiwan, R.O.C.

Next, as shown in Figure 7C, a wire bonding step can be performed to wire bond the wires 18 to the die contacts 24 (Figure 1B) on the light emitting diode (LED) dice 14 and to the substrate contacts 22 (Figure 1B) on the substrates 12. The wire bonding step can be performed using conventional wire bonding equipment. Optionally, either prior to or following the wire bonding step, a wavelength converting layer 26C (Figure 4) or 26D (Figure 5) can be deposited on the light emitting diode (LED) dice 14 for forming alternate embodiment packages 10C (Figure 4) or 10C (Figure 5). The wavelength converting layer 26C (Figure 4) or 26D (Figure 5) can be deposited using a suitable process such as precise dispensing, precise stamping, precise jetting, spraying, dispensing and screen printing, and then cured at a temperature of from 60 °C to 350 °C. In addition, the wavelength converting layer 26C (Figure 4) or 26D (Figure 5) can comprise multiple layers formed as a stack.

Next, as shown in Figure 7D, a dispensing step can be performed to form the transparent domes 20 on the light emitting diode (LED) dice 14. The transparent domes 20 can comprise a transparent material, such as silicone, epoxy, polyimide, plastic or glass. During the lens forming step, the frames 16 are configured to locate, support and shape the transparent domes 20. The transparent domes 20 can be formed using a suitable deposition process such as screen printing, precise dispensing, stamping or jetting. Following the dispensing step the transparent domes can be cured using a suitable process such as heat curing or UV curing.

Next, as shown in Figure 7E, a singulation step can be performed to singulate the wafer 28 into a plurality of light emitting diode (LED) packages 10. The singulation process is also referred to in the art as dicing. The singulation step can be performed using a process such as lasering, sawing, water jetting, etching or scribe and break, in which grooves 3 0 separate individual light emitting diode (LED) packages 10.

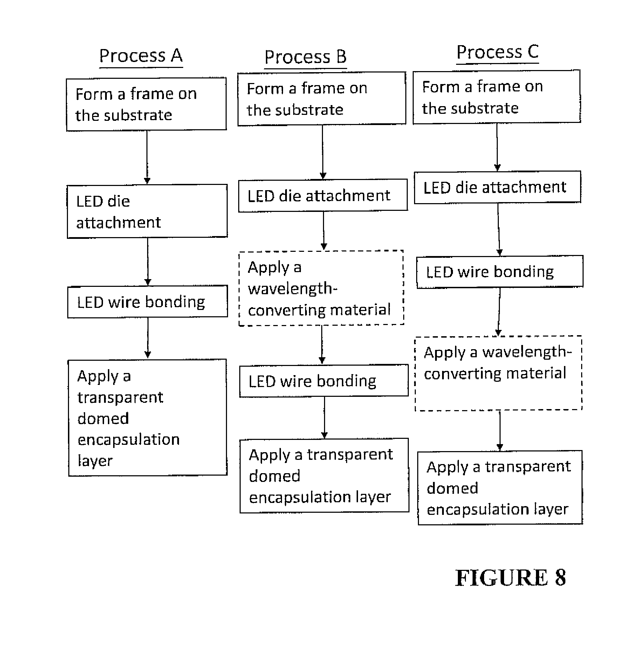

Referring to Figure 8, process flow charts for the method of Figures 7A-7E are illustrated. Process A describes the basic method. Process B describes the method with the application of a wavelength converting layer 26C (Figure 4) or 26D (Figure 5) prior to the wire bonding step. Process C describes the method with the application of a wavelength converting layer 26C (Figure 4) or 26D (Figure 5) subsequent to the wire bonding step.

Thus the disclosure describes an improved light emitting diode (LED) package and method of fabrication. While a number of exemplary aspects and embodiments have been discussed above, those of skill in the art will recognize certain modifications, permutations, additions and subcombinations thereof. It is therefore intended that the following appended claims and claims hereafter introduced are interpreted to include all such modifications, permutations, additions and subcombinations as are within their true spirit and scope.

## Claims

1. A method for fabricating a light emitting diode (LED) package comprising:
providing a substrate;
forming a frame on the substrate;
attaching a light emitting diode (LED) die to the substrate proximate to the frame;
wire bonding a wire to the light emitting diode (LED) die and to the substrate; and
dispensing a transparent encapsulation material on the frame configured to form a transparent dome and lens for encapsulating the light emitting diode (LED) die.

2. The method of claim 1 wherein the frame has a peripheral shape configured to enclose the light emitting diode (LED) die and to locate, support and shape the transparent dome during the dispensing step.

3. The method of claim 1 wherein the attaching step comprises attaching a plurality of light emitting diode (LED) dice to the substrate and the frame is configured to enclose the light emitting diode (LED) dice.

4. The method of claim 3 wherein at least one of the light emitting diode (LED) dice has different emission characteristics than a remainder of the light emitting diode (LED) dice.

5. The method of claim 1 further comprising forming a wavelength converting layer on the light emitting diode (LED) die prior to the dispensing step.

6. The method of claim 1 wherein the forming comprises a process selected from the group consisting of spin-coating, lithography, dip-coating, dispensing using a material dispensing system, printing, jetting, spraying, chemical vapor deposition (CVD), thermal evaporation, e-beam evaporation and adhesive.

7. The method of claim 1 wherein the dispensing step comprises a process selected from the group consisting of screen printing, precise dispensing, stamping, spraying and jetting.

8. The method of claim 1 wherein the substrate is contained on a semiconductor wafer or portion thereof comprising a plurality of substrates and further comprising singulating the wafer to separate the substrate from the wafer following the dispensing step.

9. A method for fabricating a light emitting diode (LED) package comprising:
providing a substrate;
forming a frame on the substrate having a peripheral shape;
attaching at least one light emitting diode (LED) die to the substrate enclosed by the peripheral shape; and
dispensing a transparent encapsulation material on the frame configured to form a transparent dome and lens for encapsulating the light emitting diode (LED) die, the frame configured to enclose the light emitting diode (LED) die and to locate, support and shape the transparent dome during the dispensing step.

10. The method of claim 9 wherein the frame has a peripheral shape selected from the group consisting of circular, polygonal, elliptical, peanut, oval, square, rectangular and oblong.

11. The method of claim 9 further comprising wire bonding a wire to the light emitting diode (LED) die and to the substrate prior to the dispensing step.

12. The method of claim 9 further comprising curing the transparent dome.

13. The method of claim 9 further comprising forming a wavelength converting layer on the light emitting diode (LED) die prior to the dispensing step.

14. The method of claim 9 wherein the attaching step comprises attaching a plurality of light emitting diode (LED) dice to the substrate and at least one of the light emitting diode (LED) dice has different emission characteristics than a remainder of the light emitting diode (LED) dice.

15. The method of claim 9 wherein the frame comprises a material selected from the group consisting of epoxy, silicone, polyimide, parylene, benzocyctobutene (BCB), polyacrylamide (PC), poly methyl methacrylate (PMMA), glass, quartz, resist and metal.

16. The method of claim 9 wherein the forming step comprises a process selected from the group consisting of spin-coating, lithography, dip-coating, dispensing sing a material dispensing system, printing, jetting, spraying, chemical vapor deposition (CVD), thermal evaporation, e-beam evaporation and adhesive.

17. The method of claim 9 wherein the substrate is contained on a semiconductor wafer or portion thereof comprising a plurality of substrates and further comprising singulating the wafer to separate the substrate from the wafer following the dispensing step.

18. A light emitting diode (LED) package comprising:
a substrate;
a light emitting diode (LED) die mounted to the substrate;
a frame on the substrate configured to enclose the light emitting diode (LED) die;
a wire bonded to the light emitting diode (LED) die and to the substrate; and
a transparent dome configured as a lens encapsulating the light emitting diode (LED) die, the frame configured to locate, support and shape the transparent dome during the dispensing step.

19. The light emitting diode (LED) package of claim 18 further comprising a plurality of light emitting diode (LED) die mounted to the substrate enclosed by the frame and encapsulated by the transparent dome.

20. The light emitting diode (LED) package of claim 19 wherein at least one of the light emitting diode (LED) dice has different emission characteristics than a remainder of the light emitting diode (LED) dice.

21. The light emitting diode (LED) package of claim 19 wherein at least one of the light emitting diode (LED) dice includes a wavelength converting layer.

22. The light emitting diode (LED) package of claim 18 wherein the frame has a peripheral shape selected from the group consisting of circular, polygonal, elliptical, peanut, oval, square, rectangular and oblong.

23. The light emitting diode (LED) package of claim 18 further comprising a wavelength converting layer on the light emitting diode (LED) die.

24. The light emitting diode (LED) package of claim 18 wherein the frame comprises a material selected from the group consisting of epoxy, silicone, polyimide, parylene, benzocyctobutene (BCB), polyacrylamide (PC), poly methyl methacrylate (PMMA), glass, quartz, resist and metal.

25. The light emitting diode (LED) package of claim 18 wherein the transparent dome comprises a material selected from the group consisting of silicone, epoxy, polyimide, plastic or glass.

26. The light emitting diode (LED) package of claim 18 wherein the frame has a thickness or height on the substrate of from 0.01 µm to 2000 µm.
